# EUROPEAN PATENT SPECIFICATION

(11) **EP 4 476 289 B1**
(45) Date of publication and mention of the grant of the patent: **14.10.2026**
(21) Application number: 23753423.5
(22) Date of filing: 09.02.2023
(51) Int. Cl.: C08L 91/06, C08L 67/00, C08L 53/00, C08K 5/00, C09K 5/14

(54) **LOW THERMAL RESISTANCE PHASE CHANGE THERMAL INTERFACE MATERIAL**
THERMISCHES PHASENÜBERGANGSMATERIAL MIT NIEDRIGEM THERMISCHEM WIDERSTAND
MATÉRIAU D'INTERFACE THERMIQUE À CHANGEMENT DE PHASE À FAIBLE RÉSISTANCE THERMIQUE

(30) Priority: 09.02.2022 US 202263308365 P
(43) Date of publication of application: 18.12.2024
(73) Proprietor: Henkel AG & Co. KGaA, 40589 Düsseldorf (DE)
(72) Inventor: BREN, Matthew, Chanhassen, Minnesota 55317 (US); VERHULST, Ryan, Minneapolis, Minnesota 55407 (US); JEWRAM, Radesh, Chanhassen, Minnesota 55317 (US)
(86) International application number: PCT/US2023/012680
(87) International publication number: WO 2023/154375

(56) References cited:
- EP-B1- 2 704 820
- WO-A1-2021/179276
- US-A1- 2003 220 432
- US-A1- 2005 148 721
- US-A1- 2016 237 332
- US-A1- 2019 048 245
- US-B1- 6 391 442

## Description

### FIELD

The present invention relates to thermal interface materials generally, and more particularly to a phase changing thermal interface material that exhibits low thermal impedance and thin bond lines.

### BACKGROUND

Thermally conductive materials are widely employed as interfaces between, for example, a heat-generating electronic component and a heat dissipater for permitting transfer of excess thermal energy from the electronic component to a thermally coupled heat dissipater. Numerous designs and materials for such thermal interfaces have been implemented, with the highest performance being achieved when gaps between the thermal interface and the respective heat transfer surfaces are substantially avoided to promote conductive heat transfer from the electronic component to the heat dissipater. The thermal interface materials therefore preferably mechanically conform to the somewhat uneven heat transfer surfaces of the respective components. Moreover, the thermal interface materials may preferably wet the heat transfer surfaces for low contact resistance. US 2003/220432 discloses a thermal interface material comprising a base thermoplastic elastomer matrix, thermally-conductive filler material, temperature-activated phase change material and optionally additives such as antioxidants, plasticizers, stabilizers, dispersing agents, colouring agents, tackifiers, adhesives, and the like; wherein the thermoplastic elastomer matrix is generally compatible with such additives so that the additives are completely dispersed

Electronic components such as semiconductors, microprocessors, resistors, and circuit boards generate a substantial amount of heat that must be removed in order for the device to function properly. High performance computing and telecommunication applications generate significant heat, and therefore require thermal interface materials with very low thermal impedance to maximize heat transfer away from sensitive electronic components. Heat transfer can be enhanced for thermal interface materials that can be compressed to very thin bond lines. Blends of rubbers, liquids, and wax matrices with metal and metal oxide powder fillers have been used for thermal interface materials. However, conventional compositions often are unable to provide the very low thermal impedance needed for high performance applications, and are not compressible to thin bondlines that would otherwise decrease thermal impedance.

Conventional thermal interface materials are also susceptible to drying and cracking over prolonged use, particularly at the high temperatures often encountered in high performance electronic component applications. This age degradation detrimentally impacts thermal performance.

### SUMMARY

By means of the present invention, thermal energy from heat-generating electronic devices, such as integrated circuits, computer chips, and the like, may be efficiently transferred to a heat dissipating structure, such as a heat sink or heat spreader. A thermal interface material of the present invention is effective in transferring the heat generated by the electronic devices, and may include a non-silicone polymer resin with a phase change material, a plasticizer, and thermally conductive particulate filler. The thermal interface material of the present invention exhibits low thermal impedance and desirable rheological properties to provide thin bond lines.

In one embodiment, the thermal interface material includes a non-silicone resin with a phase change material, and a plasticizer material including an amine-functional polyester component that is present in a concentration of between 25-50% by weight of the non-silicone resin. The thermal interface material further includes an elastomer and thermally conductive particulate filler having a particle size of less than 25 µm, such that the material exhibits a thermal impedance of less than 0.1 °C * cm²/W, a melting point of between 40-80 °C, and a melt viscosity of less than 10⁵ Pa*s.

In some embodiments, the thermally conductive filler is selected from aluminum, aluminum nitride, zinc oxide, and combinations thereof. The thermally conductive filler may have a particle size distribution including a multi-modal distribution with more than one peak of particle size. In some embodiments, a first peak of the multi-modal distribution is a particle size of between 0.1 and 3 µm, and a second peak of the multi-modal distribution is a particle size of between 8 and 12 µm.

The thermal interface material may preferably be extrudable to a film form of between 200 and 400 µm, which may reflow to a bond line of less than 50 µm, and more preferably less than 40 µm.

The tackifying agent may include a styrenic copolymer selected from styrene-butadiene-styrene (STS), styrene-ethylene/butylene-styrene (SEBS), styrene-isoprene-styrene (SIS), styrene-ethylene/propylene-styrene (SEPS), and combinations thereof.

The phase change material may be a hydrocarbon such as a wax. In some embodiments, the wax is a paraffin wax having a melting point of between 40 - 80 °C.

In another embodiment, an electronic apparatus includes an electronic component and a phase-changing thermally conductive material thermally coupled to the electronic component. The phase-changing thermally conductive material may include a non-silicone resin with a phase change material, and a plasticizer material including an amine-functional polyester copolymer that is present in a concentration of between 25-50% by weight of the non-silicone resin. The thermal interface material further includes an elastomer or elastomeric agent and thermally conductive particulate filler having a particle size of less than 25 µm, such that the material exhibits a thermal impedance of less than 0.1 °C * cm²/W, a melting point of between 40-80 °C, and a melt viscosity of less than 10⁵ Pa*s, and preferably between 10³ and 10⁴ Pa*s. The phase-changing thermally conductive material may be coated on the electronic component.

An electronic package includes a substrate, an electronic component secured to the substrate, a thermally conductive material thermally connected to the electronic component, and a heat dissipater thermally connected to the thermally conductive material. The thermally conductive material includes a non-silicone resin including a phase change material, and a plasticizer material including an amine-functional polyester copolymer that is present in a concentration of between 25-50% by weight of the non-silicone resin. The thermal interface material further includes an elastomer and thermally conductive particulate filler having a particle size of less than 25 µm, such that the material exhibits a thermal impedance of less than 0.1 °C * cm²/W, a melting point of between 40-80 °C, and a melt viscosity of between 10³ - 10⁴ Pa*s.

### BRIEF DESCRIPTION OF THE DRAWING

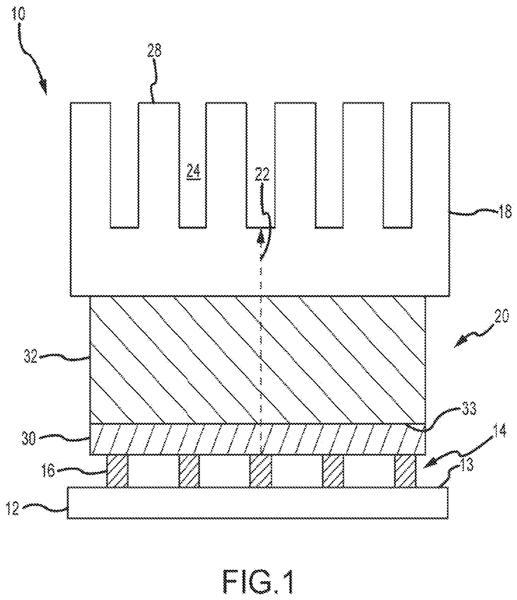

Figure 1 is a schematic illustration of an electronic component assembly of the present invention.

### DETAILED DESCRIPTION OF THE PREFERRED EMBODIMENTS

With reference now to the drawing figures, and first to Figure 1, an electronic package 10 includes a substrate 12 and an electronic component array 14 including a plurality of electronic components 16 secured to substrate 12. Electronic package 10 further includes a heat dissipater 18 and a thermal interface 20 positioned in a thermal pathway (designated by dashed arrow 22) between electronic component array 14 and heat dissipater 18. Electronic package 10 is arranged to dissipate thermal energy generated by electronic components 16 by providing a highly thermally conductive path from electronic component array 14 to a heat-absorbing fluid media 24 in contact with heat dissipater 18. In typical applications, fluid media 24 may be a gas, such as air, motivated by an air mover to absorb thermal energy from heat dissipater 18. Electronic package 10 is an example arrangement that may be modified as appropriate to accommodate a variety of electronic applications, such as data processors, data memory, communication boards, antennae, and the like. Such devices may be utilized in computing devices, communication devices, and peripherals therefor. In a particular example embodiment, electronic package 10 may be employed to support various functions in a cellular communication device.

Substrate 12 may serve one or more of a variety of functions in addition to being a support for electronic component array 14. For the purpose of simplicity in describing electronic package 10 of the present invention, substrate 12 may be a circuit board, such as a printed circuit board with electrically conductive traces on a mounting surface 13 for electrically connecting electronic components 16 as needed in the assembly. Components 16 may be electrically connected to wiring traces through soldering or other known techniques. In operation, electronic components 16 generate significant excess thermal energy which must be dissipated in order to maintain optimal performance. Electronic components 16 may be any of a variety of elements useful in an electronic process, and may include, for example, integrated circuits, resisters, transistors, capacitors, inductors, and diodes.

Thermal interface 20 provides a thermally conductive bridge between electronic component array 14 and heat dissipater 18 generally along a thermal pathway 22. Heat dissipater 18 may be thermally coupled to thermal interface 20 in a manner that most efficiently transmits thermal energy to heat dissipater 18. As schematically illustrated, heat dissipater 18 may have a configuration that incorporates a relatively high surface area, such as through fins 28. The use of heat dissipaters is well understood, and it is contemplated that conventional and custom designs may be utilized in the arrangements of the present invention.

### Resin

Thermal interface 20 is a material that may include a non-silicone hydrocarbon resin composition of one or more rubbers, liquids, and waxes. The resin provides a matrix for incorporating thermally conductive fillers. The hydrocarbon resin composition may include, for example, saturated and unsaturated rubber compounds. Example saturated rubber compounds include ethylene-propylene rubbers, polyethylene/butylene, polyethylene-butylene-styrene, polyethylene-propylene-styrene, hydrogenated polyalkyldiene mono-ols, hydrogenated polyalkyldiene diols, hydrogenated polyisoprene, and polyolefin elastomer.

Other example non-silicone resins include various thermoplastic materials that may or may not be naturally tacky. In some embodiments, the resin may have a softening temperature, such as a melting temperature, a phase transition temperature, or a phase change temperature, that is less than or within a normal operating temperature of electronic components 16. In other embodiments, however, the resin may have a softening temperature that is higher than the normal operating temperature of electronic components 16. The resin softening temperature may, for example, be within a range of between 40 °C to 175 °C, and more preferably within a range of between 40 °C to 125 °C, and still more preferably within a range of between 40 °C and 85 °C.

Example thermoplastic resin materials include thermoplastic/elastomer blends and alloys such as non-cross-linked polyolefins that are thermoplastic and thermoplastic vulcanizates, which are otherwise known as thermoplastic rubbers. Non-silicone resin materials may be employed in the compositions of the present invention to acts as a carrier or network for phase change materials, thermally conductive particulate filler, and any other additives that may be used in the compositions.

In some embodiments, silyl-modified resins may be used in the matrices of the present invention. The resins are preferably non-silicone, wherein no more than a trace amount of silicone is contained in the composition. In some embodiments, no silicone is contained in the composition. The silyl-modified polymer may have a flexible backbone for lower modulus and glass transition temperature, such as a backbone of polyether, polyester, polyurethane, polyacrylate, polyisoprene, polybutadiene, polystyrene-butadiene, or polybutylene isoprene.

The resin component of the present compositions may preferably include a phase change material having a softening temperature (including a melting temperature, a phase transition temperature, or a phase change temperature) or temperature range within or below an operating temperature or temperature range of electronic components 16, and particularly the electronic components 16 to which thermal interface 20 is thermally coupled. The temperature-activated phase change material preferably changes from a solid state to a liquid state and from a liquid state to a solid state within a temperature range of about 30 °C to about 90 °C, and more preferably between 40 °C and 80 °C. The phase change material can be any suitable material such as a natural wax like beeswax or carnuba wax, a petroleum-based wax like paraffin wax, or a synthetic wax like polyethylene glycol, polyethylene, polyhydric alcohols, or chlorinated naphthalene.

An exemplary phase change material is a wax, such as a paraffin wax. Paraffin waxes are a mixture of solid hydrocarbons having the general formula CₙH₂ₙ₊₂ and having melting points in the range of about 40 °C to about 140 °C, and more preferably in the range of 40 °C to 80 °C. Polymer waxes include polyethylene waxes and polyproplylene waxes, and typically have a range of melting point from about 40 °C to about 160 °C. Other exemplary phase change material include low melting alloys having a melting point of between about 40 °C and about 80 °C.

The resin, including the phase change material, may be present in a range of about 0.1 up to about 50 percent by weight of the total composition; in some embodiments, the resin, including the phase change material, may be present in the range of about 0.3 up to about 20 percent by weight of the total composition; in some embodiments, the resin, including the phase change material, may be present in the range of about 0.5 up to about 10 percent by weight of the total composition; in some embodiments, the resin, including the phase change material, may be present in the range of about 1 up to about 5 percent by weight of the total composition; in some embodiments, the resin, including the phase change material, may be present in the range of 1 up to 3 percent by weight of the total composition. For the purposes hereof, the "total composition" may mean thermal interface 20.

### Complimentary Plasticizer Material

Applicants have found that a high performance thermal interface material may be achieved with a unique blend of components, including a blend of a phase change material and a complimentary plasticizer material. The unique compositions of the present invention exhibit low thermal resistance and reliable thermal performance over a prolonged use lifetime at high temperatures exceeding 125 °C. The compositions of the present invention, employing the blend of components generally, and specifically the blend of phase change material and plasticizer material, provide resistance to aging (performance decline) at high temperatures.

A plasticizer material useful in the compositions of the present invention is preferably compatible with the phase change material, as described above. The plasticizer material acts as a rheology modifier to lower the viscosity of the composition as temperature increases. However, the plasticizer material may not share similar softening temperature properties to the phase change material. Preferably, the plasticizer material is or includes an amine-functional polyester copolymer that is capable of wetting the thermally conductive particulate filler. The wetting of the thermally conductive particulate filler by the plasticizer enhances filler affinity toward the resin. Such affinity aids in reducing the viscosity of the composition.

It has been found that use of the second phase change material within a specific concentration range relative to the resin is important to the beneficial functional characteristics described herein. In particular, the complimentary plasticizer material preferably is present in the range of about 20 up to about 60 percent by weight of the resin; in some embodiments, the complimentary plasticizer material is present in the range of 25 up to 50 percent by weight of the resin; in some embodiments, the complimentary plasticizer material is present in the range of 25 up to 40 percent by weight of the resin. Loading concentrations of the complimentary plasticizer of less than 20 percent by weight of the resin results in inadequate temperature stability of the composition, while loading concentrations of the complimentary plasticizer of greater than 60 percent by weight of the resin interferes with the phase change characteristics of the composition. Preferably, the thermal interface material includes an amine-functional polyester copolymer in a concentration range of between 25 and 50 percent by weight of the resin.

### Thermally Conductive Particles

In order to achieve the desired low thermal impedance of the thermally conductive interface, the compositions of the present invention include thermally conductive particles dispersed therein. The particles may be both thermally conductive and electrically conductive. Alternatively, the particles may be thermally conductive and electrically insulating. Importantly, the particles are preferably wettable by the complimentary plasticizer material described above. Various thermally conductive particles may be useful in the compositions of the present invention. It has been found, however, that thermally conductive particles selected from aluminum, aluminum nitride, zinc oxide, and combinations thereof may be most useful in the compositions of the present invention.

The particulate filler material may be in the form granular powder, whiskers, fibers, or any other suitable form. The particles may be substantially spherical, plate-like, rod-like, or a combination thereof. In some embodiments, the thermally conductive particles may have a particle size of less than 25 µm, with the term "particle size" meaning particle diameter or effective particle diameter. In some embodiments, the thermally conductive particles may have a particle size of between 0.01 and 25 µm. In some embodiments, the thermally conductive particles may be monodisperse. In some embodiments, the thermally conductive particles, which may comprise one or more material species, may have a particle size distribution with particles having a particle size of between 0.01 and 25 µm.

In some embodiments, the particle size distribution may be multi-modal, with more than one concentration peak of particle sizes of between 0.01 and 25 µm. In some embodiments, a first concentration peak of the multi-modal distribution is a particle size of between 0.1 and 3 µm, and a second concentration peak of the multi-modal distribution is a particle size of between 8 and 12 µm. The first concentration peak of the multi-modal distribution may comprise between 10 and 90 percent by weight of the total thermally conductive filler; in some embodiments, the first concentration peak of the multi-modal distribution may comprise between 15 and 80 percent by weight of the total thermally conductive filler; in some embodiments, the first concentration peak of the multi-modal distribution may comprise between 15 and 50 percent by weight of the total thermally conductive filler; in some embodiments, the first concentration peak of the multi-modal distribution may comprise between 15 and 30 percent by weight of the total thermally conductive filler. The second concentration peak of the multi-modal distribution may comprise between 10 and 90 percent by weight of the total thermally conductive filler; in some embodiments, the second concentration peak of the multi-modal distribution may comprise between 15 and 80 percent by weight of the total thermally conductive filler; in some embodiments, the second concentration peak of the multi-modal distribution may comprise between 25 and 60 percent by weight of the total thermally conductive filler. The multi-modal distribution may include more than two concentration peaks of particle sizes.

In some embodiments, the thermally conductive particulate filler may comprise a tri-modal particle size distribution of particle sizes between 0.01 and 25 µm. A first concentration peak of the tri-modal distribution is an aluminum nitride particle size of between 0.1 and 3 µm, a second concentration peak of the tri-modal distribution is an aluminum particle size of between 8 and 12 µm, and a third concentration peak of the tri-modal distribution is a zinc oxide particle size of between 0.01 and 0.5 µm. The first concentration peak of the tri-modal distribution comprises between 15 and 35 percent by weight of the total thermally conductive filler. The second concentration peak comprises between 25 and 60 percent by weight of the total thermally conductive filler. The third concentration peak comprises between 15 and 35 percent by weight of the total thermally conductive filler.

The thermally conductive particulate filler may comprise at least 25 percent by weight aluminum particles, preferably at least 35 percent by weight aluminum particles, and more preferably at least 40 percent by weight aluminum particles.

In some embodiments, the particle sizes described above may represent average particle diameters (d₅₀).

The thermally conductive particulate filler may be dispersed in the resin and present in the composition at a loading concentration of between 20 and 98 percent by weight of the total composition. In some embodiments, the thermally conductive particulate filler comprises between 40 and 97 percent by weight of the total composition. In some embodiments, the thermally conductive particulate filler comprises between 50 and 95 percent by weight of the total composition. It is desirable that sufficient thermally conductive particles are provided so that the thermally conductive interface formed from the composition exhibits a thermal conductivity of at least 0.5 W/m*K, preferably at least 1 W/m*K, and more preferably at least 2 W/m*K.

### Secondary Plasticizer

The compositions of the present invention may include a secondary plasticizer in addition to the complimentary plasticizer described herein. The secondary plasticizer may be employed to adjust the viscosity of the dispensable mass, particularly under shear, and to maintain solid state and melt viscosities within desired ranges. Secondary plasticizers useful in the present compositions are those which are effective in facilitating fluency of the coherent mass making up the composition. The secondary plasticizers of the present invention may preferably be lowvolatility liquids that reduce the viscosity of the composition. In some embodiments, the secondary plasticizer may exhibit a viscosity of less than 1000 cP (1000 mPa·s) at 25 °C. In another embodiment, the secondary plasticizer may exhibit a viscosity of less than 500 cP (500 mPa·s) at 25 °C. In a further embodiment, the secondary plasticizer may exhibit a viscosity of less than 100 cP (100 mPa·s) at 25 °C.

In some embodiments, the secondary plasticizer may represent about 0.1 to about 25 percent by weight of the composition. In some embodiments, the secondary plasticizer may represent about 0.5 to about 10 percent by weight of the composition. In some embodiments, the secondary plasticizer may represent about 1 to about 5 percent by weight of the composition. The secondary plasticizer may preferably be present at less than 20 percent by weight of the composition.

Example secondary plasticizers include sebacates, adipates, terephthalates, dibenzoates, gluterates, phthalates, azelates, benzoates, sulfonamides, organophosphates, glycols, polyethers, trimellitates, polybutadienes, epoxies, amines, acrylates, thiols, polyols, and isocyanates. A preferred secondary plasticizer is a trimellitate.

### Elastomeric agent

The compositions of the present invention preferably include an elastomeric agent. Example elastomers may include a styrenic copolymer selected from styrene-butadiene-styrene (STS), styrene-ethylene/butylene-styrene (SEBS), styrene-isoprene-styrene (SIS), styrene-ethylene/propylene-styrene (SEPS), and combinations thereof. The elastomeric agent may comprise between 0.1 to about 25 percent by weight of the composition. In some embodiments, the elastomeric agent may comprise between 0.5 and 10 percent by weight of the composition. In some embodiments, the elastomeric agent may comprise between 0.8 and 5 percent by weight of the composition. In some embodiments, the elastomeric agent may comprise between 1 and 3 percent by weight of the composition.

### Optional Additives

In accordance with some embodiments of the present invention, the compositions described herein may further comprise one or more additives such as anti-oxidants, stabilizers, dispersing agents, coloring agents, adhesives, wetting agents, flame retardants, extenders, and corrosion inhibitors.

### Thermal Interface Material Properties

In preferred embodiments, the thermal interface material exhibits a thermal impedance of less than 0.1 °C * cm²/W, preferably less than 0.05 °C * cm²/W. In some embodiments, the thermal interface material exhibits a thermal impedance of between 0.01 and 0.1 °C * cm²/W.

The final thickness of the applied thermal interface material, following application between the heat generating and heat dissipating components, is referred to as the bond line thickness. The value of the bond line thickness is determined, in part, by the flowability of the thermal interface material when being heated by the heat generating component. Bond line thickness (BLT) is related to thermal impedance (TI) and thermal conductivity (TC) by the formula TI = BLT/TC, such that lower BLT results in lower thermal impedance at the same thermal conductivity. In some embodiments, when subjected to a pressure of 40 psi (276 Pa) and heated to 80 °C, the thermal interface material of the present invention has a bond line thickness of less than 50 µm, preferably less than 40 µm, and more preferably less than 25 µm. In some embodiments, the bond line thickness is between 5 and 50 µm.

The thermal interface material preferably exhibits a melt viscosity (viscosity of material in liquid phase) of less than 10⁵ Pa*s, and preferably less than 10⁴ Pa*s. In some embodiments, the melt viscosity of the thermal interface material is between 10³ and 10⁴ Pa*s. The melt viscosity is measured at a temperature above the melting point of the phase change material in the thermal interface. The melting point of the phase change material is considered to be the melting point of the thermal interface material, and is preferably between 40 and 160 °C, more preferably between 40 and 125 °C, and still more preferably between 40 and 80 °C.

### Articles

The thermally conductive compositions of the present invention may be used to make a variety of shaped articles. The articles may be employed as interfaces between a heat-generating device and a heat-dissipating device. The heat-generating device operatively transfers heat to the interface article, causing the interface article to melt at operating temperatures below 120 °C, and more often below 80 °C. As the phase change material melts, it forms a liquid film at the contact surfaces of the interface article, electronic component, and heat dissipater. The film comprising the phase change material lowers the thermal resistance of the contact surfaces. The resin matrix of the thermally conductive interface provides a network for containing the liquid phase change material, and prevents it from flowing out of the interface.

The composition may be melt-extruded into a film with a low thickness. By contrast, conventional films made from silicone-based filler compositions are generally much thicker. It has been found that non-silicone resin films may be advantageous over silicone version for certain applications. For example, thin silicone films tend to have poor handling characteristics, and may require support structures to maintain integrity. Moreover, silicone resins and particulate filler materials may be incompatible due to different densities and a low viscosity of the silicone resin. Thus, the compositions of the present invention are preferably non-silicone.

### Example

The following composition was used in the fabrication of a thermal interface material:

| Material | Weight (g) |
|---|---|
| Paraffin Wax | 25-40 |
| Amine-functional polyester copolymer | 8-12 |
| Styrene-butadiene-styrene PSA | 10-40 |
| Trimellitate plasticizer | 20-45 |
| Antioxidant | 3-7 |
| Wetting agent | 10-15 |
| Zinc Oxide | 100-500 |
| Aluminum (1 µm) | 300-500 |
| Aluminum (9 µm) | 600-1000 |

The composition exhibited a thermal impedance of 0.1 °C * cm²/W and a melting point range of 40 to 55 °C.

## Claims

1. A thermal interface material, comprising:
a non-silicone resin comprising a phase change material;
a plasticizer comprising an amine-functional polyester copolymer present in the material at between 25 and 50 percent by weight of the non-silicone resin;
an elastomeric agent;
thermally conductive particulate filler wettable by the plasticizer and having a particle size of less than 25 µm,
wherein the thermal interface material exhibits a thermal impedance of less than 0.5 °C * cm²/W, a melting point of between 40 and 80 °C, and a melt viscosity of less than 10⁵ Pa*s.

2. The thermal interface material as in Claim 1, including between 50 and 95 percent by weight of the thermally conductive particulate filler, between 1 and 5 percent by weight of the non-silicone resin comprising the phase change material, and between 1 and 3 percent by weight of the elastomeric agent.

3. The thermal interface material as in Claim 1 wherein the thermally conductive particulate filler is selected from aluminum, aluminum nitride, zinc oxide, and combinations thereof.

4. The thermal interface material as in Claim 3, wherein aluminum comprises at least 40 percent by weight of the thermally conductive particulate filler, preferably the thermally conductive filler is aluminum.

5. The thermal interface material as in Claim 1 wherein the thermally conductive particulate filler is present in a multi-modal particle size distribution, including a first concentration peak at between 0.1 and 3 µm and a second concentration peak at between 8 and 12 µm.

6. The thermal interface material as in Claim 5 wherein the first concentration peak comprises between 15 and 35 percent by weight of the thermally conductive particulate filler, and the second concentration peak comprises between 40 and 60 percent by weight of the thermally conductive particulate filler.

7. The thermal interface material as in Claim 6, including a third concentration peak that comprises between 15 and 35 percent by weight of the thermally conductive particulate filler.

8. The thermal interface material as in Claim 6 wherein the first concentration peak comprises aluminum nitrate particles, and the second concentration peak comprises aluminum particles.

9. The thermal interface material as in Claim 7 wherein the third concentration peak comprises zinc oxide particles.

10. The thermal interface material as in Claim 1 being extrudable to a film that is reflowable to a bond line of less than 50 µm.

11. The thermal interface material as in Claim 1 wherein the elastomeric agent is a styrenic copolymer selected from styrene-butadiene-styrene (SBS), styrene-ethylene/butylene-styrene (SEBS), styrene-isoprene-styrene (SIS), styrene-ethylene/propylene-styrene (SEPS), and combinations thereof.

12. The thermal interface as in Claim 1 wherein the non-silicone resin has a melting point of less than 150 °C, preferably the non-silicone resin includes paraffin wax.

13. An electronic apparatus, comprising:
an electronic component; and
the thermal interface of Claim 1 thermally coupled to the electronic component.

14. The electronic apparatus as in Claim 15 wherein the thermal interface is coated on the electronic component.

15. An electronic package, comprising:
a substrate;
an electronic component secured to the substrate;
a thermally conductive material thermally connected to the electronic component, the thermally conductive material comprising a non-silicone resin including a phase change material, an amine functional polyester copolymer present at between 25 and 50 percent by weight of the non-silicone resin, an elastomeric agent, and thermally conductive particulate filler having a particle size of less than 25 µm, wherein the thermal interface material exhibits a thermal impedance of less than 0.1 °C * cm²/W, a melting point of between 40 and 80 °C, and a melt viscosity of less than 10⁵ Pa*s; and
a heat dissipater thermally connected to the thermally conductive material.

## Patentansprüche

1. Thermisches Grenzflächenmaterial, umfassend:
ein Nichtsilikonharz, umfassend ein Phasenwechselmaterial;
einen Weichmacher, umfassend ein aminfunktionelles Polyestercopolymer, das in dem Material zu zwischen 25 und 50 Gewichtsprozent des Nichtsilikonharzes vorliegt;
ein elastomeres Mittel;
thermisch leitfähiger partikelförmiger Füllstoff, der durch den Weichmacher benetzbar ist und eine Teilchengröße von weniger als 25 µm aufweist,
wobei das thermische Grenzflächenmaterial eine thermische Impedanz von weniger als 0,5 °C * cm²/W, einen Schmelzpunkt zwischen 40 und 80 °C und eine Schmelzviskosität von weniger als 10⁵ Pa*s aufweist.

2. Thermisches Grenzflächenmaterial nach Anspruch 1, einschließend zu zwischen 50 und 95 Gewichtsprozent den thermisch leitfähigen teilchenförmigen Füllstoff, zu zwischen 1 und 5 Gewichtsprozent das Nichtsilikonharz, das das Phasenwechselmaterial umfasst, und zu zwischen 1 und 3 Gewichtsprozent das elastomere Mittel.

3. Thermisches Grenzflächenmaterial nach Anspruch 1, wobei der thermisch leitfähige teilchenförmige Füllstoff ausgewählt ist aus Aluminium, Aluminiumnitrid, Zinkoxid und Kombinationen davon.

4. Thermisches Grenzflächenmaterial nach Anspruch 3, wobei Aluminium zu mindestens 40 Gewichtsprozent den thermisch leitfähigen teilchenförmigen Füllstoff umfasst, wobei vorzugsweise der thermisch leitfähige Füllstoff Aluminium ist.

5. Thermisches Grenzflächenmaterial nach Anspruch 1, wobei der thermisch leitfähige teilchenförmige Füllstoff in einer multimodalen Teilchengrößenverteilung vorliegt, einschließlich eines ersten Konzentrationspeaks bei zwischen 0,1 und 3 µm und eines zweiten Konzentrationspeaks bei zwischen 8 und 12 µm.

6. Thermisches Grenzflächenmaterial nach Anspruch 5, wobei der erste Konzentrationspeak zu zwischen 15 und 35 Gewichtsprozent den thermisch leitfähigen teilchenförmigen Füllstoff umfasst und der zweite Konzentrationspeak zu zwischen 40 und 60 Gewichtsprozent den thermisch leitfähigen teilchenförmigen Füllstoff umfasst.

7. Thermisches Grenzflächenmaterial nach Anspruch 6, einschließend eine dritte Konzentrationsspitze, die zu zwischen 15 und 35 Gewichtsprozent den thermisch leitfähigen teilchenförmigen Füllstoff umfasst.

8. Thermisches Grenzflächenmaterial nach Anspruch 6, wobei der erste Konzentrationspeak Aluminiumnitratteilchen umfasst und der zweite Konzentrationspeak Aluminiumteilchen umfasst.

9. Thermisches Grenzflächenmaterial nach Anspruch 7, wobei der dritte Konzentrationspeak Zinkoxidteilchen umfasst.

10. Thermisches Grenzflächenmaterial nach Anspruch 1, das zu einer Folie extrudierbar ist, die zu einer Verbindungsfuge von weniger als 50 µm aufschmelzbar ist.

11. Thermisches Grenzflächenmaterial nach Anspruch 1, wobei das elastomere Mittel ein Styrol-Copolymer ist, ausgewählt aus Styrol-Butadien-Styrol (SBS), Styrol-Ethylen/Butylen- Styrol (SEBS), Styrol-Isopren-Styrol (SIS), Styrol-Ethylen/Propylen-Styrol (SEPS) und Kombinationen davon.

12. Thermisches Grenzflächenmaterial nach Anspruch 1, wobei das Nichtsilikonharz einen Schmelzpunkt von weniger als 150 °C aufweist, wobei das Nichtsilikonharz vorzugsweise Paraffinwachs einschließt.

13. Elektronische Einrichtung, umfassend:
eine elektronische Komponente; und
die thermische Grenzfläche nach Anspruch 1, thermisch gekoppelt an die elektronische Komponente.

14. Elektronische Einrichtung nach Anspruch 15, wobei die elektronische Komponente mit der thermischen Grenzfläche beschichtet ist.

15. Elektronische Baugruppe, umfassend:
ein Substrat;
eine an dem Substrat befestigte elektronische Komponente;
ein thermisch leitfähiges Material, das thermisch mit der elektronischen Komponente verbunden ist, wobei das thermisch leitfähige Material ein Nichtsilikonharz, das ein Phasenwechselmaterial einschließt, ein aminfunktionelles Polyestercopolymer, das mit zwischen 25 und 50 Gewichtsprozent des Nichtsilikonharzes vorhanden ist, ein elastomeres Mittel und einen thermisch leitfähigen teilchenförmigen Füllstoff mit einer Teilchengröße von weniger als 25 µm umfasst, wobei das thermische Grenzflächenmaterial eine thermische Impedanz von weniger als 0,1 °C * cm²/W, einen Schmelzpunkt zwischen 40 und 80 °C und eine Schmelzviskosität von weniger als 10⁵ Pa*s aufweist; und
einen Wärmeableiter, der thermisch mit dem thermisch leitfähigen Material verbunden ist.

## Revendications

1. Matériau d'interface thermique, comprenant :
une résine non-silicone comprenant un matériau à changement de phase ;
un plastifiant comprenant un copolymère de polyester à fonctionnalité amine présent dans le matériau à raison de 25 à 50 pour cent en poids de la résine non-silicone ;
un agent élastomère ;
une charge particulaire thermoconductrice mouillable par le plastifiant et ayant une taille de particules inférieure à 25 µm,
dans lequel le matériau d'interface thermique présente une impédance thermique inférieure à 0,5 °C * cm²/W, un point de fusion compris entre 40 et 80 °C, et une viscosité à l'état fondu inférieure à 10⁵ Pa*s.

2. Matériau d'interface thermique selon la revendication 1, comportant entre 50 et 95 pour cent en poids de la charge particulaire thermoconductrice, entre 1 et 5 pour cent en poids de la résine non-silicone comprenant le matériau à changement de phase, et entre 1 et 3 pour cent en poids de l'agent élastomère.

3. Matériau d'interface thermique selon la revendication 1, dans lequel la charge particulaire thermoconductrice est choisie parmi aluminium, nitrure d'aluminium, oxyde de zinc, et combinaisons de ceux-ci.

4. Matériau d'interface thermique selon la revendication 3, dans lequel l'aluminium comprend au moins 40 pour cent en poids de la charge particulaire thermoconductrice, de préférence la charge thermoconductrice est l'aluminium.

5. Matériau d'interface thermique selon la revendication 1, dans lequel la charge particulaire thermoconductrice est présente dans une distribution multimodale de taille de particules, comportant un premier pic de concentration compris entre 0,1 et 3 µm et un deuxième pic de concentration compris entre 8 et 12 µm.

6. Matériau d'interface thermique selon la revendication 5, dans lequel le premier pic de concentration comprend entre 15 et 35 pour cent en poids de la charge particulaire thermoconductrice, et le deuxième pic de concentration comprend entre 40 et 60 pour cent en poids de la charge particulaire thermoconductrice.

7. Matériau d'interface thermique selon la revendication 6, comportant un troisième pic de concentration
qui comprend entre 15 et 35 pour cent en poids de la charge particulaire thermoconductrice.

8. Matériau d'interface thermique selon la revendication 6, dans lequel le premier pic de concentration comprend des particules de nitrate d'aluminium, et le deuxième pic de concentration comprend des particules d'aluminium.

9. Matériau d'interface thermique selon la revendication 7, dans lequel le troisième pic de concentration comprend des particules d'oxyde de zinc.

10. Matériau d'interface thermique selon la revendication 1, étant extrudable en un film qui est refusionnable en une ligne de liaison inférieure à 50 µm.

11. Matériau d'interface thermique selon la revendication 1, dans lequel l'agent élastomère est un copolymère styrénique choisi parmi styrène-butadiène-styrène (SBS), styrène-éthylène/butylène-styrène (SEBS), styrène-isoprène-styrène (SIS), styrène-éthylène/propylène-styrène (SEPS), et combinaisons de ceux-ci.

12. Interface thermique selon la revendication 1, dans laquelle la résine non-silicone a un point de fusion inférieur à 150 °C, de préférence la résine non-silicone comporte de la cire de paraffine.

13. Appareil électronique, comprenant :
un composant électronique ; et
l'interface thermique selon la revendication 1 couplée thermiquement au composant électronique.

14. Appareil électronique selon la revendication 15, dans lequel l'interface thermique est revêtue sur le composant électronique.

15. Module électronique, comprenant :
un substrat ;
un composant électronique fixé au substrat ;
un matériau thermoconducteur connecté au composant électronique, le matériau thermoconducteur comprenant une résine non-silicone comportant un matériau à changement de phase, un copolymère de polyester à fonctionnalité amine présent à raison de 25 à 50 pour cent en poids de la résine non-silicone, un agent élastomère, et la charge particulaire thermoconductrice ayant une taille de particules inférieure à 25 µm, dans lequel le matériau d'interface thermique présente une impédance thermique inférieure à 0,1 °C * cm²/W, un point de fusion compris entre 40 et 80 °C, et une viscosité à l'état fondu inférieure à 10⁵ Pa*s ; et
un dissipateur de chaleur relié thermiquement au matériau thermoconducteur.
